# EUROPEAN PATENT APPLICATION

(11) **EP 1 826 772 A1**
(43) Date of publication of application: **29.08.2007**
(21) Application number: 06121148.8
(22) Date of filing: 22.09.2006
(51) Int. Cl.: G11C 11/15, G11C 11/16

(54) **Magnetic memory device and method of writing data into magnetic memory device**

(30) Priority: 22.02.2006 KR 20060017028
(71) Applicant: Samsung Electronics Co., Ltd., Suwon-si, Gyeonggi-Do (KR)
(72) Inventor: Kim, Tae-wan, Yongin-si, Gyeonggi-do (KR); Hwang, In-jun, Giheung-gu, Yongin-si, Gyeonggi-do (KR); Cho, Young-jin, Yeongtong-gu, Suwon-si, Gyeonggi-do (KR); Kim, Kee-won, Giheung-gu, Yongin-si, Gyeonggi-do (KR)
(74) Representative: Greene, Simon Kenneth

(57) **Abstract**

Provided are a magnetic memory device and a method of writing data into the magnetic memory device. The magnetic memory device comprises a plurality of word lines and a plurality of bit lines defining a plurality of unit cell regions, a transistor disposed in each of the unit cell regions, and a magnetic tunneling junction (MTJ) element series connected to the transistor and having an MTJ cell sandwiched between first and second pad layers forming a magnetic field at both sides of the MTJ cell upon current flow through said first and second pad layers, the second pad layer being connected to a bit line; wherein a drain of each transistor is connected to the first pad layer in a corresponding cell region and a source thereof is connected to the second pad layer in an adjacent unit cell region, and the gates of the transistors of adjacent cells are connected to a same word line.

## Description

### BACKGROUND OF THE INVENTION

The present invention relates to a memory device, and more particularly, to a magnetic memory device having high cell selectivity in which a driving voltage can be reduced, and a method of writing data into the magnetic memory device.

Magnetic memory devices include a magnetic tunneling junction (MTJ) cell having a tunneling layer as a storage node and magnetic layers disposed above and below the tunneling layer. The magnetic memory devices are nonvolatile memory devices which write bit data using a resistance characteristic of the MTJ cell.

The MTJ cell has low resistance when magnetization directions of magnetic layers of the MTJ cell are the same. The MTJ cell has high resistance when magnetization directions of the magnetic layers are opposite to one another. When the MTJ cell has low resistance, it can be regarded that predetermined bit data, for example, 1 is written into a magnetic memory device. In addition, when the MTJ cell has high resistance, it can be regarded that predetermined bit data, for example, 0 is written into the magnetic memory device.

Bit data written into the magnetic memory device in this way is read by measuring resistance or current of the MTJ cell and by comparing the resistance or current with a reference value.

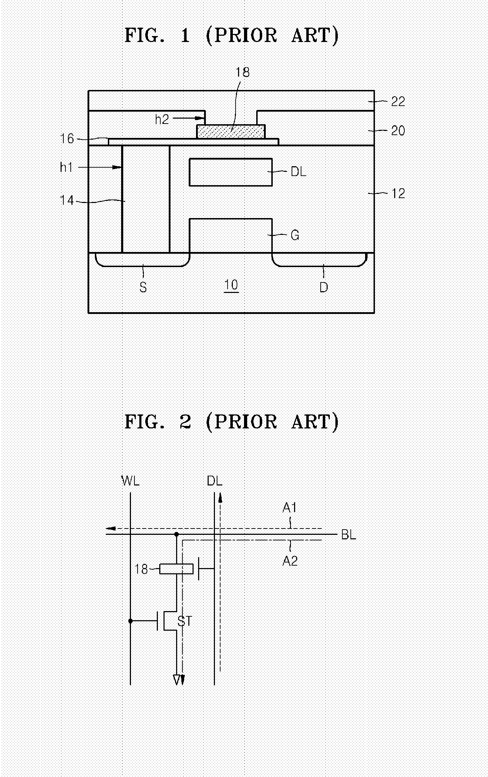

A variety of magnetic memory devices (hereinafter, referred to as a conventional magnetic memory device) having this operating characteristic have been introduced, and FIG. 1 shows an example thereof.

FIG. 1 is a cross-sectional view of a conventional magnetic memory device. Referring to FIG. 1, a gate electrode G is disposed on a semiconductor substrate 10. Source and drain regions S and D are respectively formed on the semiconductor substrate 10 between the gate electrode G and two field oxide layers (not shown) adjacent to the gate electrode G. The gate electrode G, and the source and drain regions S and D constitute a field effect transistor (hereinafter, referred to as a transistor). A digital line DL exists in a place that is separated from the gate electrode G by a predetermined vertical distance. A portion of a magnetic field required for a write operation of a magnetic RAM is formed by the digit line DL. The digit line DL and the transistor are covered with an interlevel dielectric (ILD) layer 12. A via hole h1 exists in the ILD layer 12, and the via hole h1 is filled with a conductive plug 14. A conductive pad 16 exists on the ILD layer 12. The conductive pad 16 covers an upper surface of the conductive plug 14 and extends up to the digit line DL by a predetermined length. A MTJ cell 18 is disposed on a predetermined region of the conductive pad 16. The MTJ cell 18 is disposed immediately on the digit line DL. An ILD layer 20 that covers the conductive pad 16 and the MTJ cell 18 exists on the ILD layer 12. A via hole h1 through which an upper surface of the MTJ cell 18 is exposed is formed in the ILD layer 12. A bit line 22 that fills the via hole h2 exists on the ILD layer 12.

FIG. 2 shows a flow of current in write and read operations of a conventional magnetic RAM shown in FIG. 1. In FIG. 2, a dotted line A1 denotes a current path in a write operation and a chain thin line A2 denotes a current path in a read operation.

Referring to FIG. 2, current flows through a selected bit line BL in a write operation. Thus, even though a cell to be written is selected by a selected word line WL, a magnetic field generated by current that flows through the selected bit line BL affects the selected MTJ cell 18 and unselected another MTJ cell (not shown) connected to the selected bit line BL. As such, the possibility that undesired data may be written into the unselected another MTJ cell is high. In the conventional magnetic RAM, this means MTJ cell selectivity is low.

### SUMMARY OF THE INVENTION

The present invention provides a magnetic memory device having high cell selectivity in which a driving voltage can be reduced.

According to an aspect of the present invention, there is provided a magnetic
memory device, the magnetic memory device comprising: a plurality of word lines and a plurality of bit lines defining a plurality of unit cell regions; a transistor disposed in each of the unit cell regions; and a magnetic tunneling junction (MTJ) element forming a group with the transistor and having an MTJ cell and first and second pad layers forming a magnetic field at both sides of the MTJ cell, wherein a drain of each transistor is connected to the first pad layer in a corresponding cell region and a source thereof is connected to the second pad layer in an adjacent unit cell region, and a gate of each transistor is connected to a corresponding word line in a corresponding unit cell region and a drain thereof is connected top a bit line in the corresponding unit cell region.

According to another aspect of the present invention, there is provided a method of writing data into a magnetic memory device, the method comprising writing data into a magnetic tunneling junction (MTJ) element in a form of polarization in a selected memory region on one word line of the magnetic memory device, wherein a magnetic field with respect to one side of the MTJ element is switched by a transistor in a corresponding memory region and a magnetic field with respect to the other side of the MTJ cell is switched by a transistor of an adjacent cell on the same unselected word line.

The magnetic field switched by the transistor in the corresponding cell region
may be formed by a first current that passes a transistor in a corresponding cell region, and the magnetic field switched by the transistor in the adjacent cell may be formed by a second current that passes an MTJ cell in a corresponding cell region.

Thicknesses of the first and second pad layers may be less than 100 nm. The bit line and the MTJ cell may be spaced apart from each other by a gap of at least 300 nm. According to the present invention, an MTJ cell selectivity can be increased and a driving power of the magnetic memory device can be reduced.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view of a conventional magnetic memory device;
FIG. 2 is a cross-sectional view of a current path that flows through a magnetic memory device when the magnetic memory device of FIG. 1 operates;
FIG. 3 is an equivalent circuit diagram of a memory device according to an embodiment of the present invention;
FIG. 4 is a cubic diagram showing schematic arrangement of main elements of a memory device according to another embodiment of the present invention;
FIG. 5 is an extending view of arrangement of elements of a word line based on a current path, for understanding of the memory device of FIG. 4;
FIGS. 6A and 6B are an extracted perspective view and a cross-sectional view of a schematic construction of a magnetic tunneling junction (MTJ) cell of a magnetic memory device according to the present invention;
FIG. 7 is an equivalent circuit diagram for explaining a method of writing data into a magnetic memory device according to an embodiment of the present invention; and
FIG. 8 is an equivalent circuit diagram for explaining a method of reading data from a magnetic memory device according to an embodiment of the present invention.

### DETAILED DESCRIPTION OF THE INVENTION

The present invention will now be described more fully with reference to the accompanying drawings, in which exemplary embodiments of the invention are shown. In the drawings, the thicknesses of layers and regions are exaggerated for clarity.

A magnetic memory device (hereinafter, referred to as a memory device according to the present invention) according to an embodiment of the present invention will now be described.

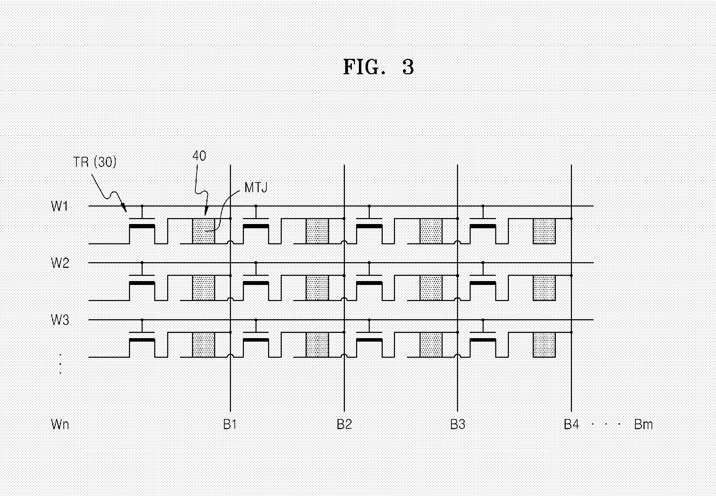

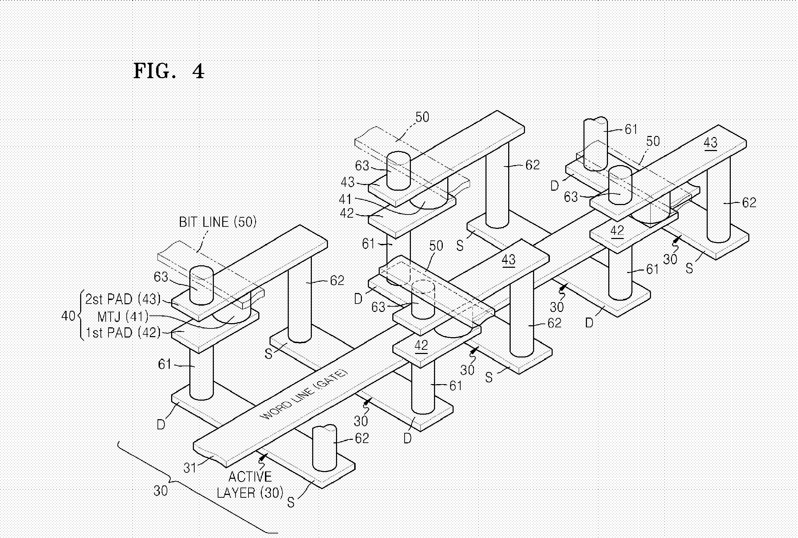

FIG. 3 is an equivalent circuit diagram of a memory device according to an embodiment of the present invention, and FIG. 4 is a cubic diagram of a schematic configuration of a memory device according to another embodiment of the present invention.

Referring to FIG. 3, bit lines B1, B2, B3, B4, ... , and Bm in a latitudinal direction and word lines W1, W2, W3, ... , and Wn in a longitudinal direction are disposed on an X-Y matrix and a unit cell region is defined by the bit lines and the word lines.

One transistor 30 and an MTJ element 40 are disposed in each unit cell region defined by the bit lines B1, B2, B3, B4, ... , and Bm and the word lines W1, W2, W3, ... , and Wn. Here, the MTJ element 40 includes an MTJ cell 41 and first and second pad layers (42 and 43 of FIG. 4), which are formed at both sides (up and down on the drawing) of the MTJ cell 41 that forms a magnetic field required for polarization of the MTJ cell 41. An active layer of the transistor TR and the MTJ element 40 are serially connected to each other in each unit cell region, and this connection structure is repeatedly formed in all unit cell regions. Thus, each transistor TR whose gate is connected to one of the word lines W1 to Wn and the MTJ element 40 are repeatedly and serially connected to each other. A drain of the transistor 30 and a connection node of the MTJ cell 40 are connected to adjacent bit lines B1 to Bm, and a source of each transistor is electrically connected to the bit lines B1 to Bm through the MTJ element 40 in adjacent another unit cell region.

Referring to FIG. 4, which shows a memory device according to an embodiment of the present invention, active layers of the transistor 30 are disposed in parallel. In this case, adjacent active layers have sources S and drains D, which cross one another in different directions. Plugs 62 and 63 are vertically formed in the drains D and the sources S of two adjacent active layers 30. The first pad layer 42 and the second pad layer 43 of the MTJ element 40 are disposed on each of the plugs 62 and 63. The opposing first and second pad layers 42 and 43 are parallel to each other and the MTJ cell 41 is disposed therebetween. The plug 63 is formed on the second pad layer 43. The plug 63 is connected to the bit line 50 on the second pad layer 43. According to the current embodiment, thicknesses of the first and second pad layers 42 and 43 may be less than 100 nm and widths thereof may be less than 100 nm. The bit line 50 and the second pad layer 43 that is adjacent to the bit line 50 may be spaced apart from each other by a gap of at least 300 nm.

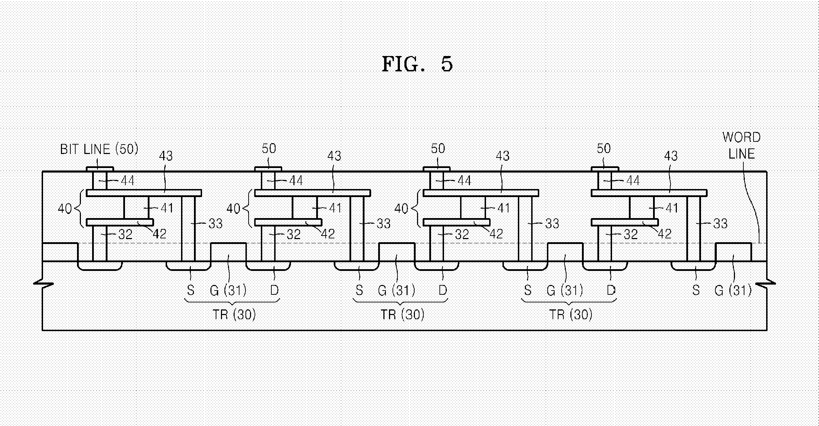

FIG. 5 is a schematic cross-sectional view of the transistor 30 and the MTJ element 40, which are disposed in a zigzag shape, for understanding of the memory device shown in FIG. 4. In FIG. 5, a gate G of each transistor corresponds to a single word line, as indicated by a dotted line. As illustrated in FIG. 5, the transistor 30 and the MTJ element 40 are serially connected to each other, like MTJ-TR-MTJ- , ... , and -TR. A portion for connecting the source S and the MTJ element 40 is connected to the bit line 50 through a plug 44.

The memory device having the above-described structure is different from a conventional memory device in terms of circuit and thus, a corresponding data writing and reproducing method is needed.

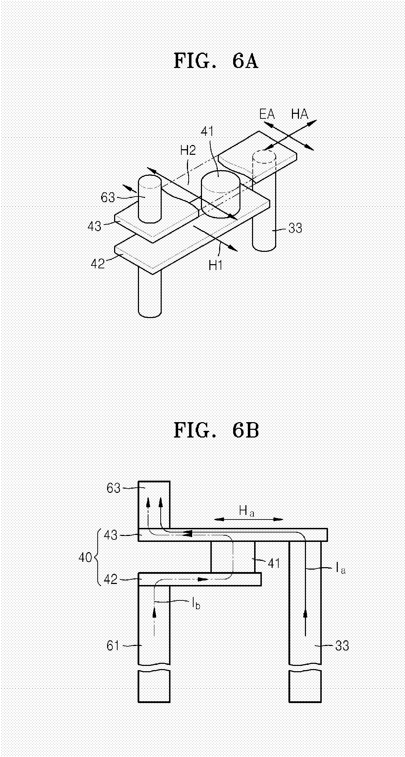

FIGS. 6A and 6B are respectively an extracted perspective view and a cross-sectional view of the MTJ element 40 of the magnetic memory device according to the present invention, which show a current path for writing data through the first and second pad layers 42 and 43.

The MTJ cell 41 is disposed between the first and second pad layers 42 and 43, which are parallel thereto. The MTJ cell 41 is disposed between a middle portion of the second pad layer 43 and one end (a right end on the drawing) of the first pad layer 42. The plug 63 to be connected to a bit line (not shown) and a plug 33 to be connected to a source (not shown) in another cell region are disposed at both sides of the second pad layer 43. A plug 61 to be a drain of a transistor (not shown) is disposed under the other end of the first pad layer 42. A current flows through two paths Iₐ and I_{b}. One is a first path through a transistor, the first pad layer 42, the MTJ cell 40, and the second pad layer 43. The other is a second path through a core 33 connected to a transistor in another cell region and the second pad layer 43. Thus, a current that helps data in being stored in the MTJ cell 41 is a sum (Iₐ + I_{b}) of currents flowing through the two paths. The currents flowing the two paths are formed at both sides (up and down on the drawing) of the MTJ cell 41 and thus, a magnetic field required for the MTJ cell 41 is also formed at a low current. Here, the magnetic field is spaced apart from a bit line and a plug connected to the bit line. Thus, the magnetic field caused by the bit line does not affect the MTJ cell 41.

In FIGS. 6A and 6B, Ha and Ea represent a hard axis direction and an easy axis direction of the MTJ cell 41, respectively. When magnetic polarization of the MTJ cell 41 is aligned in the easy axis Ea direction, the alignment state is stably kept even after a magnetic field is removed. On the other hand, when magnetic polarization of the MTJ cell 41 is aligned in the hard axis Ha direction, the alignment state returns to its original state or is inverted in the Ea direction. Currents flow through the current paths Iₐ and I_{b} illustrated in FIG. 6B or in opposite directions to the current paths Iₐ and I_{b}. Magnetic fields H1 and H2 in the Ea direction that affects a local region of the MTJ cell 41 are generated around the first and second pad layers 42 and 43. Magnetic polarization of the MTJ cell 41 is aligned in the Ea direction by the magnetic fields H1 and H2. Here, polarization is not inverted by one of the current Iₐ or I_{b} but is inverted by a sum of the two currents Iₐ and I_{b}. That is, the currents Iₐ and I_{b} should be smaller than a minimum current required for polarization. The sum of the currents Iₐ and I_{b} should be larger than the minimum current.

The whole method of driving the memory device by which a current flow is induced will now be described. When data is written into the selected MTJ cell 40 of the memory device by a magnetic field, one word line and three bit lines are selected. In this case, data is stored in the MTJ element 40 that is directly connected to a middle bit line.

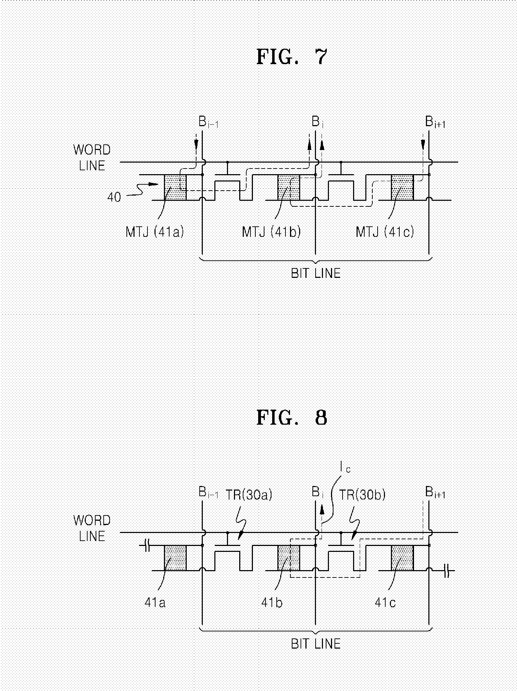

Referring to FIG. 7, three bit lines Bᵢ₋₁, Bᵢ, and Bᵢ₊₁ (where i is a natural number) are always selected when data is stored in an MTJ cell. An MTJ cell in which polarization occurs is an MTJ cell (MTJb) in a unit cell region corresponding to the middle bit line Bᵢ. If the middle bit line Bᵢ is grounded and a predetermined current (or a predetermined voltage) is applied to the bit lines Bᵢ₋₁ and Bᵢ₊₁ at both sides of the bit line Bᵢ when one word line is opened, the two current paths Iₐ and I_{b} are generated. For explanatory conveniences, a cell region corresponding to each bit line is considered to be located at a left side of a bit line. Thus, a current on the first path lₐ flows a corresponding bit line Bi through a transistor TRa in a corresponding cell region and a pad layer at one side of the MTJ cell 40 via the MTJ cell 40a in an adjacent unit cell region (on the left of the drawing). A current on the second path I_{b} passes through the cell (MTJb) of the MTJ cell 40 via the bit line Bᵢ₊₁ and the transistor TRb in an adjacent unit cell region (on the right of the drawing). Thus, polarization occurs in the MTJ cell 40 of the selected bit line due to the currents of the two paths Iₐ and I_{b} so that data can be stored in the MTJ cell 40. However, the currents flow through only one path in the MTJ cell 40 of the bit lines at both sides of the selected bit line and polarization does not occur due to the currents.

FIG. 8 illustrates a method of reading data stored by the above-described method. For example, in order to obtain bit information from one unit memory region, a corresponding bit line Bᵢ and a corresponding word line are selected. Simultaneously, a bit line Bᵢ₊₁ of adjacent bit lines to which a drain of a corresponding transistor is connected (on the right on the drawing) is selected. Thus, if a predetermined voltage is applied to the two selected bit lines Bᵢ and Bᵢ₊₁ when a corresponding word line is opened, a current I_{c} that passes through the MTJ 41 b in a corresponding unit cell region is generated and bit information is obtained by a value of the current.

The memory device according to the present invention has a different structure from a conventional memory device and a method of writing data into the memory device. Unlike the prior art, an MTJ cell is isolated from a bit line and a pad layer that forms a magnetic field is provided at both sides of the MTJ cell. A conventional digit line is not necessarily required in the memory device according to the present invention and may be added in any case.

As described above, the magnetic memory device according to the present invention is a unit for controlling magnetic polarization of a free magnetic layer of an MTJ cell. Pad layers are formed at both sides of the MTJ cell and paths of currents for forming a magnetic field in the MTJ cell are divided into two transistors.

In this way, the magnetic memory device according to the present invention writes bit data without using a magnetic field generated in a bit line but using a magnetic field generated in the pad layers that contact both sides of the MTJ cell. Thus, bit data can be written only into a selected MTJ cell and bit data can be prevented from being written into an unselected MTJ cell in this procedure. This means that the magnetic memory device according to the present invention has high selectivity. Furthermore, two current paths are generated so that currents are divided into two transistors and a current load on the transistor is reduced.

In addition, thicknesses of upper and lower electrode pad layers are small, less than 100 nm, and widths thereof are small, less than 100 nm. Thus, an intensity of a magnetic field generated in each unit current of the pad layers can be increased. This means that a current used to record bit data can be reduced. As a result, a driving power of the magnetic memory device can be reduced.

While the present invention has been particularly shown and described with reference to exemplary embodiments thereof, it will be understood by those of ordinary skill in the art that various changes in form and details may be made therein without departing from the spirit and scope of the present invention as defined by the following claims. For example, the construction of a digit line may be changed or the first and second pad layers 42 and 43 may be multi-layers or a material used in forming the first and second pad layers 42 and 43 may be specified by those of ordinary skill in the art. In addition, a shielding means for improving a blocking effect of a magnetic field generated from a bit line between the bit line and the pad layer may be further provided.

## Claims

1. A magnetic memory device comprising:
a plurality of word lines and a plurality of bit lines defining a plurality of unit cell regions;
a transistor disposed in each of the unit cell regions; and
a magnetic tunneling junction (MTJ) element forming a group with the transistor and having an MTJ cell and first and second pad layers forming a magnetic field at both sides of the MTJ cell,
wherein a drain of each transistor is connected to the first pad layer in a corresponding cell region and a source thereof is connected to the second pad layer in an adjacent unit cell region, and
a gate of each transistor is connected to a corresponding word line in a corresponding unit cell region and a drain thereof is connected top a bit line in the corresponding unit cell region.

2. The magnetic memory device of claim 1, wherein thicknesses of the first and second pad layers are less than 100 nm.

3. The magnetic memory device of claim 1 or 2, wherein the bit line and the MTJ cell are spaced apart from each other by a gap of at least 300 nm.

4. A method of writing data into a magnetic memory device, the method comprising writing data into a magnetic tunneling junction (MTJ) element in a form of polarization in a selected memory region on one word line of the magnetic memory device,
wherein a magnetic field with respect to one side of the MTJ element is switched by a transistor in a corresponding memory region and a magnetic field with respect to the other side of the MTJ cell is switched by a transistor of an adjacent cell on the same unselected word line.

5. The method of claim 4, wherein the magnetic field switched by the transistor in the corresponding cell region is formed by a first current that passes a transistor in a corresponding cell region, and
the magnetic field switched by the transistor in the adjacent cell is formed by a second current that passes an MTJ cell in a corresponding cell region.

6. The method of claim 4 or 5, wherein a sum of the first and second currents has a value greater than a minimum current required for polarization of an MTJ element, and each of the first and second currents has a value less than the minimum current.

7. The method of claim 4, 5 or 6, wherein the magnetic memory device comprises:
a plurality of word lines and a plurality of bit lines defining a plurality of unit cell regions;
a transistor disposed in each of the unit cell regions; and
a magnetic tunneling junction (MTJ) element forming a group with the transistor and having an MTJ cell and first and second pad layers forming a magnetic field at both sides of the MTJ cell,
wherein a drain of each transistor is connected to the first pad layer in a corresponding cell region and a source thereof is connected to the second pad layer in an adjacent unit cell region, and
a gate of each transistor is connected to a corresponding word line in a corresponding unit cell region and a drain thereof is connected top a bit line in the corresponding unit cell region.

8. The method of claim 7, wherein thicknesses of the first and second pad layers are less than 100 nm.

9. The method of claim 7 or 8, wherein the bit line and the MTJ cell are spaced apart from each other by a gap of at least 300 nm.
